(19) **Europäisches Patentamt / European Patent Office / Office européen des brevets**

(11) **EP 3 161 498 B1**

(12) **FASCICULE DE BREVET EUROPEEN**

(45) Date de publication et mention de la délivrance du brevet:
**25.04.2018 Bulletin 2018/17**

(21) Numéro de dépôt: **15742347.6**

(22) Date de dépôt: **25.06.2015**

(51) Int Cl.:
**G01R 31/36** $^{(2006.01)}$    **H01M 10/48** $^{(2006.01)}$

(86) Numéro de dépôt international:
**PCT/FR2015/051712**

(87) Numéro de publication internationale:
**WO 2015/197982 (30.12.2015 Gazette 2015/52)**

(54) **SYSTEME DE BATTERIES D'ACCUMULATEURS A MESURE DE TENSION FIABILISEE**

SYSTEM AUS AKKUMULATORBATTERIEN MIT ZUVERLÄSSIGERER SPANNUNGSMESSUNG

SYSTEM OF ACCUMULATOR BATTERIES WITH MORE RELIABLE VOLTAGE MEASUREMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.06.2014 FR 1456009**

(43) Date de publication de la demande:
**03.05.2017 Bulletin 2017/18**

(73) Titulaire: **Renault S.A.S.**
**92100 Boulogne-Billancourt (FR)**

(72) Inventeurs:
• **PALMIERI, Michaël**
  **38610 Gieres (FR)**
• **BERANGER, Marc**
  **38330 Biviers (FR)**
• **CARCOUET, Sébastien**
  **38450 Vif (FR)**
• **CORDESSES, Lionel**
  **78180 Montigny Le Bretonneux (FR)**
• **DERBEY, Alexis**
  **38420 Revel (FR)**
• **MENSLER, Michel**
  **78180 Montigny Le Bretonneux (FR)**
• **DANG-VAN-NHAN, Christophe**
  **94800 Villejuif (FR)**

(74) Mandataire: **GIE Innovation Competence Group**
  **310, avenue Berthelot**
  **69372 Lyon Cedex 08 (FR)**

(56) Documents cités:
WO-A1-2010/074290      DE-A1-102011 005 603
DE-A1-102012 222 720   US-A1- 2006 012 337
US-A1- 2008 164 882    US-A1- 2008 180 106

**Description**

L'invention concerne les batteries d'accumulateurs électrochimiques. Celles-ci peuvent par exemple être utilisées dans le domaine des transports électriques et hybrides ou les systèmes embarqués.

Un accumulateur électrochimique a habituellement une tension nominale de l'ordre de grandeur suivant:

>   1.2 V pour des batteries de type NiMH,
>   3.3 V pour une technologie Lithium ion phosphate de fer, LiFePO4,
>   3.7 V pour une technologie de type Lithium ion à base d'oxyde de cobalt.

Ces tensions nominales sont trop faibles par rapport aux exigences de la plupart des systèmes à alimenter. Pour obtenir le niveau de tension adéquat, on place en série plusieurs accumulateurs. Pour obtenir de fortes puissances et capacités, on place plusieurs groupes d'accumulateurs en série. Le nombre d'étages et le nombre d'accumulateurs en parallèle dans chaque étage varient en fonction de la tension, du courant et de la capacité souhaités pour la batterie. L'association de plusieurs accumulateurs est appelée une batterie d'accumulateurs.

La charge d'un accumulateur se traduit par une croissance de la tension à ses bornes. Chaque technologie d'accumulateur présente un profil de charge qui lui est propre, par exemple défini par l'évolution de la tension d'un accumulateur dans le temps pour un courant de charge donné.

On considère un accumulateur chargé par exemple lorsque, sous un courant donné, celui-ci a atteint un niveau de tension nominal défini par son processus électrochimique. Si la charge est interrompue avant que cette tension ne soit atteinte, l'accumulateur n'est pas complètement chargé. L'accumulateur peut aussi être considéré comme chargé lorsque la charge a duré un temps prédéterminé ou encore lorsque le courant de charge, alors que l'accumulateur est maintenu à tension constante, a atteint une valeur seuil minimale.

Du fait de dispersions de fabrication, les accumulateurs présentent en pratique des caractéristiques différentes. Ces différences, relativement faibles lorsque la batterie est neuve, s'accentuent avec l'usure hétérogène des accumulateurs de la batterie. Même en associant des accumulateurs d'un même lot de fabrication dans une batterie, des dispersions subsistent.

La plage de fonctionnement d'un accumulateur de type Li - ion à base d'oxyde de cobalt est typiquement comprise entre 2,7 V et 4,2 V. Une utilisation hors de cette plage peut induire une détérioration irréversible des accumulateurs de la batterie. Une tension inférieure à la plage d'utilisation induit la détérioration de la cellule. Une surcharge peut conduire à une destruction d'un accumulateur, à son usure accélérée, ou à une explosion par un phénomène d'emballement thermique.

Des dispositifs de contrôle respectifs surveillent ainsi le niveau de tension de chaque étage. Chacun de ces dispositifs de contrôle est accolé à un étage et est généralement alimenté par cet étage. Chaque dispositif de contrôle communique avec une unité centrale pour lui fournir le niveau de tension mesuré pour son étage. L'unité centrale génère des commandes d'interruption de charge ou de décharge de chaque étage, en fonction des niveaux de tension reçus.

La charge de tous les étages est par exemple interrompue lorsque l'étage le plus chargé atteint une limite haute de la plage de fonctionnement. La tension de l'étage le moins chargé est alors égale à une tension inférieure à la limite haute.

L'unité centrale commande également l'interruption de la décharge de la batterie lorsque l'étage le moins chargé atteint une limite basse de la plage de fonctionnement.

Les mesures et les décisions d'interruption étant distantes, la communication entre les dispositifs de contrôle et l'unité centrale est primordiale pour garantir l'intégrité de la batterie.

Le document US2008/180106 décrit un système de gestion de batterie haute tension comprenant des modules de contrôles chaînés.

Le document DE10 2011 005603 décrit un système de gestion de batterie commun à plusieurs cellules. Chaque cellule comporte un circuit respectif pour réaliser une mesure de tension redondante aux bornes de la cellule.

Selon une première solution de communication connue de l'état de la technique, l'unité centrale est connectée à un bus de données. Ce bus de données est connecté à chaque dispositif de contrôle par une isolation galvanique, du fait des différents niveaux de tension appliqués à chacun de ces dispositifs de contrôle.

Selon une deuxième solution de communication connue de l'état de la technique, les dispositifs de contrôle communiquent de proche en proche par l'intermédiaire de connexions filaires. L'unité centrale est connectée à deux dispositifs de contrôle aux extrémités de la batterie par l'intermédiaire de dispositifs d'isolation galvanique.

Pour réduire le coût de cette deuxième solution, le document US6411912 décrit une communication de proche en proche entre les dispositifs de contrôle par l'intermédiaire d'une translation de niveau de tension. Une telle structure permet notamment de se dispenser d'isolateur galvanique et donc de réduire le coût global de la batterie.

Cependant, une telle structure s'avère insuffisante pour répondre à certaines exigences de sécurité, la fiabilité des mesures de tension effectuées par les dispositifs de contrôle étant insuffisante. Pour répondre à cette exigence, il est connu de dédoubler les dispositifs de contrôle de chaque étage, ce qui induit un surcoût non négligeable.

L'invention vise à résoudre cet inconvénient. L'invention porte ainsi sur un système de batterie d'accumulateurs, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :

- la figure 1 est une représentation schématique d'un premier exemple de système de batterie d'accumulateurs selon l'invention ;
- la figure 2 est une représentation schématique d'un deuxième exemple de système de batterie d'accumulateurs selon l'invention ;
- la figure 3 représente un premier exemple d'association de dispositifs de contrôle ;
- la figure 4 représente schématiquement un exemple de dispositif de contrôle ;
- la figure 5 représente un deuxième exemple d'association de dispositifs de contrôle ;
- la figure 6 représente un dispositif de contrôle additionnel associé à un dispositif de contrôle d'une extrémité de la batterie ;
- la figure 7 représente une variante de l'exemple d'association de dispositifs de contrôle de la figure 3 ;
- la figure 8 représente une variante de l'exemple d'association de dispositifs de contrôle de la figure 5 ;
- les figures 9 et 10 représentent des variantes d'un dispositif de contrôle destiné à charger un étage ;
- la figure 11 est une représentation schématique d'un troisième exemple de système de batterie d'accumulateurs selon l'invention ;
- la figure 12 est un diagramme illustrant différents seuils mis en oeuvre en fonction des signaux reçus.

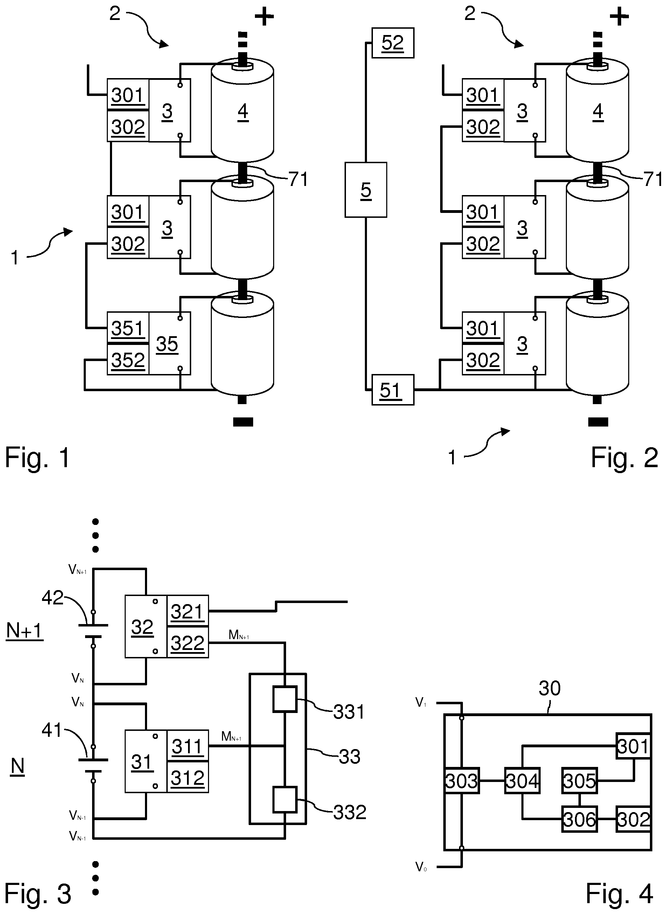

La figure 1 illustre schématiquement un système de batterie d'accumulateurs 1 selon un premier mode de réalisation de l'invention. La figure 2 illustre schématiquement un système de batterie d'accumulateurs 1 selon un deuxième mode de réalisation de l'invention.

Un système 1 selon ces modes de réalisation peut par exemple être mis en oeuvre pour assurer l'entraînement d'un moteur électrique. Le système 1 comprend une batterie 2 incluant des étages d'accumulateurs électrochimiques 4 connectés en série. La batterie 2 comprend par exemple un grand nombre d'étages 4, incluant typiquement entre 20 et 100 accumulateurs connectés en série en fonction de la tension nécessaire et du type d'accumulateurs utilisé. Les étages 4 sont connectés en série par l'intermédiaire de connexions électriques de puissance 71. Chaque étage 4 comporte un dispositif de contrôle qui lui est accolé. Chaque dispositif de contrôle comporte une interface d'entrée et une interface de sortie. Les dispositifs de contrôle sont configurés pour mesurer la différence de potentiel aux bornes de l'étage auquel ils sont accolés. Les dispositifs de contrôle 3 sont également configurés pour communiquer de proche en proche, notamment des valeurs de différences de potentiels mesurées.

Dans le mode de réalisation de la figure 1, les dispositifs de contrôle 3 sont par exemple des dispositifs de contrôle esclaves, incluant une interface d'entrée 301 et une interface de sortie 302. Le dispositif de contrôle 35 est un dispositif de contrôle maître, incluant une interface d'entrée 351 et une interface de sortie 352. Une telle structure permet par exemple au dispositif de contrôle 35 de transmettre des commandes aux dispositifs de contrôle 3, en se dispensant d'isolation galvanique entre les dispositifs de contrôle esclaves 3 et le dispositif de contrôle maître 35.

Dans le mode de réalisation de la figure 2, les dispositifs de contrôle 3 sont tous des dispositifs de contrôle esclaves, incluant une interface d'entrée 301 et une interface de sortie 302. Une unité centrale déportée 5 est connectée aux extrémités de la chaine de communication formée par les dispositifs de contrôle 3, par l'intermédiaire de dispositifs d'isolation galvanique 51 et 52. L'unité centrale 5 récupère typiquement des valeurs de différence de potentiel mesurées par les dispositifs de contrôle 3, et fournit des commandes à ces dispositifs de contrôle 3.

La figure 3 représente un premier exemple d'association de dispositifs de contrôle au niveau de deux étages 41 et 42 connectés en série. L'étage 41 est par exemple d'indice N et l'étage 42 est alors d'indice N+1 dans la connexion en série entre les bornes négative et positive de la batterie 2. Le potentiel au niveau de la borne négative de l'étage 41 sera notée $V_{n-1}$, le potentiel au niveau de la borne positive de l'étage 41 sera notée $V_n$ et égal au potentiel au niveau de la borne négative de l'étage 42, le potentiel au niveau de la borne positive de l'étage 42 sera notée $V_{n+1}$. En supposant que la différence de potentiel moyenne aux bornes des étages soit égale à Vcel (on suppose que la tension nominale de chaque étage est identique), le potentiel $V_{n-1}$ est approximativement égal à (N-1)*Vcel.

Un premier dispositif de contrôle 31 est accolé et connecté électriquement à l'étage 41. Le premier dispositif de contrôle 31 est alimenté par les potentiels $V_n$ et $V_{n-1}$. Un deuxième dispositif de contrôle 32 est accolé et connecté électriquement à l'étage 42. Le deuxième dispositif de contrôle 32 est alimenté par les potentiels $V_{n+1}$ et $V_n$.

Dans l'exemple illustré à la figure 3, la communication s'effectue du dispositif de contrôle 32 vers le dispositif de contrôle 31. Le dispositif de contrôle 31 comporte une interface d'entrée 311 et une interface de sortie 312. Le dispositif de contrôle 32 comporte une interface d'entrée 321 et une interface de sortie 322. L'interface de sortie 322 est connectée à l'interface d'entrée 311 par l'intermédiaire d'un convertisseur de niveau de potentiel 33. L'interface d'entrée 321 est connectée à l'interface de sortie du dispositif de contrôle de l'étage d'indice N+2. L'interface de sortie 312 est connectée à l'interface d'entrée du dispositif de contrôle de l'étage d'indice N-1.

Le dispositif de contrôle 32 mesure la différence de potentiel aux bornes de l'étage 42, numérise cette différence de potentiel (éventuellement avec un codage à un unique bit par comparaison à un seuil) et applique sur la sortie 322 la différence de potentiel numérisée (notée $M_{n+1}$) sous la forme d'une séquence numérique incluant au moins deux niveaux logiques égaux respectivement à $V_{n+1}$ et $V_n$, par exemple au moyen d'un interrupteur appliquant soit le potentiel $V_{n+1}$ et $V_n$ en sortie. La séquence numérique est appliquée sur une entrée du convertisseur de niveau de potentiel 33. Une sortie du convertisseur 33 est connectée à l'interface d'entrée 311. Une borne de référence du convertisseur 33 est connectée au potentiel $V_{n-1}$. Le convertisseur 33 est configuré pour convertir les niveaux logiques de la séquence numérique appliquée sur son entrée en des niveaux logiques compris entre les potentiels d'alimentation du dispositif de contrôle 31. La séquence numérique sur l'entrée du convertisseur 33 présente deux niveaux logiques respectivement égaux à $V_{n+1}$ et $V_n$, le convertisseur 33 appliquant une séquence numérique sur l'entrée 311 avec deux niveaux logiques compris entre $V_n$ et $V_{n-1}$.

Le convertisseur 33 forme ici un diviseur de tension entre sa borne de référence et son entrée. Le convertisseur 33 comporte par exemple une résistance 331 connectée entre la sortie 322 et l'entrée 311, et une résistance 332 connectée entre l'entrée 311 et la borne de référence de ce convertisseur 33. Par exemple, si les résistances 331 et 332 présentent une même valeur de résistance, la séquence numérique appliquée sur l'entrée 311 présente deux niveaux logiques égaux respectivement à $(V_{n-1} + (V_{n+1} - V_{n-1})/2)$ et $(V_{n-1} + (V_n - V_{n-1})/2)$. D'autres rapports de division de tension peuvent bien entendu être utilisés, par exemple avec une résistance 331 ayant une valeur de résistance double de celle de la résistance 332.

Le dispositif de contrôle 31 mesure la différence de potentiel aux bornes de l'étage 41 et numérise (éventuellement avec un codage à un unique bit par comparaison à un seuil) cette différence de potentiel (notée $M_n$). Par ailleurs, le dispositif de contrôle 31 décode la séquence numérique reçue sur l'entrée 311 afin de lire la différence de potentiel $M_{n+1}$ de l'étage 42. En outre, le dispositif de contrôle 31 mesure les niveaux logiques de la séquence numérique reçue sur l'entrée 311. À partir des niveaux logiques mesurés sur la séquence numérique reçue sur l'entrée 311, le dispositif de contrôle 31 extrapole la différence de potentiel aux bornes de l'étage 42, en se basant notamment sur la connaissance de la loi de conversion du convertisseur 33. La différence de potentiel extrapolée est notée $E_{n+1}$. Si le dispositif de contrôle 31 mesure deux niveaux logiques $NL1_{n+1}$ et $NL2_{n+1}$, si le convertisseur 33 forme un diviseur de tension avec des résistances 331 et 332 identiques, on obtient $E_{n+1}$ par la relation suivante :

$$E_{n+1} = |NL1_{n+1} - NL2_{n+1}| * 2$$

Ainsi, l'extrapolation de la différence de potentiel $E_{n+1}$ permet d'assurer une redondance de mesure du potentiel aux bornes de l'étage 42. Cette redondance peut être utilisée soit pour transmettre de façon chaînée les valeurs $M_{n+1}$ et $E_{n+1}$, soit pour transmettre la valeur $M_{n+1}$ avec un indicateur de fiabilité (soit une valeur binaire, soit une valeur d'écart) à une unité centrale ou à un dispositif de contrôle maître.

Le dispositif de contrôle 31 applique sélectivement sur la sortie 312 soit la différence de potentiel numérisée $M_n$, soit la différence de potentiel $M_{n+1}$ décodée, soit la différence de potentiel extrapolée $E_{n+1}$, soit un indicateur de la fiabilité de la différence de potentiel mesurée $M_{n+1}$.

La figure 4 est une représentation schématique d'un exemple de dispositif de contrôle 30 pouvant être utilisé comme dispositif de contrôle 31 ou 32. Le dispositif de contrôle 30 mesure la différence entre les potentiels $V_1$ et $V_0$ appliqués aux bornes d'un étage, par l'intermédiaire d'un circuit de mesure 303. Le dispositif de contrôle 30 comporte un convertisseur analogique/numérique 304. Le circuit de mesure 303 applique la différence de potentiel mesurée sur une entrée du convertisseur analogique/numérique 304. Le convertisseur analogique/numérique 304 applique la différence de potentiel mesurée sur une entrée d'une unité de traitement 306. Le dispositif de contrôle 30 est alimenté par ces potentiels $V_1$ et $V_0$.

Le dispositif de contrôle 30 comporte une interface d'entrée 301 et une interface de sortie 302. L'interface 301 reçoit une séquence numérique incluant une mesure de potentiel, soit mesurée par un dispositif de contrôle adjacent, soit provenant d'un autre dispositif de contrôle et répercutée par un dispositif de contrôle adjacent. Le dispositif de contrôle 30 comprend un décodeur 305. L'interface d'entrée 301 reçoit la séquence numérique et l'applique sur une entrée du décodeur 305. Le décodeur 305 décode la séquence numérique et applique la mesure de différence de potentiel sur l'unité de traitement 306.

Par ailleurs, l'interface d'entrée 301 applique les potentiels des niveaux logiques de la séquence numérique reçue sur l'entrée du convertisseur analogique/numérique 304. Le convertisseur analogique/numérique 304 fournit les valeurs numériques de ces niveaux logiques de la séquence numérique. L'unité de traitement 306 extrapole la différence de potentiel de l'étage ayant émis la séquence numérique, sur la base d'une différence entre ces niveaux logiques,

**4**

comme détaillé auparavant en référence au dispositif de contrôle 31. L'unité de traitement 306 peut également déterminer la fiabilité de la mesure de différence de potentiel décodée, en la comparant à la différence de potentiel extrapolée, en vérifiant que l'écart entre ces valeurs est inférieur à un seuil, ou en calculant simplement l'écart entre ces valeurs.

L'unité de traitement 306 commande les informations qui doivent être transmises par l'intermédiaire de l'interface de sortie 302, par exemple la différence de potentiel mesurée par le circuit 303 et numérisée par le convertisseur 304, la différence de potentiel extrapolée par l'unité de traitement 306 sur la base des niveaux logiques appliqués sur l'interface d'entrée 301, la différence de potentiel décodée par le décodeur 305, un indicateur de fiabilité de la différence de potentiel décodée, ou une valeur d'écart entre la différence de potentiel décodée et la différence de potentiel extrapolée.

L'interface de sortie 302 transmet les informations sélectionnées sous la forme d'une séquence numérique incluant au moins deux niveaux logiques égaux respectivement à $V_n$ et $V_{n-1}$, soit les potentiels d'alimentation de ce dispositif de contrôle 30.

Un système 1 basé sur de tels dispositifs de contrôle 30 permet une communication de proche en proche d'un niveau de différence de potentiel mesuré, avec une vérification par un autre dispositif de contrôle du niveau de différence de potentiel mesuré, et sans problématique d'isolation galvanique entre différents dispositifs de contrôle.

Les dispositifs de contrôle 30 peuvent par exemple être mis en oeuvre sous la forme de microcontrôleurs.

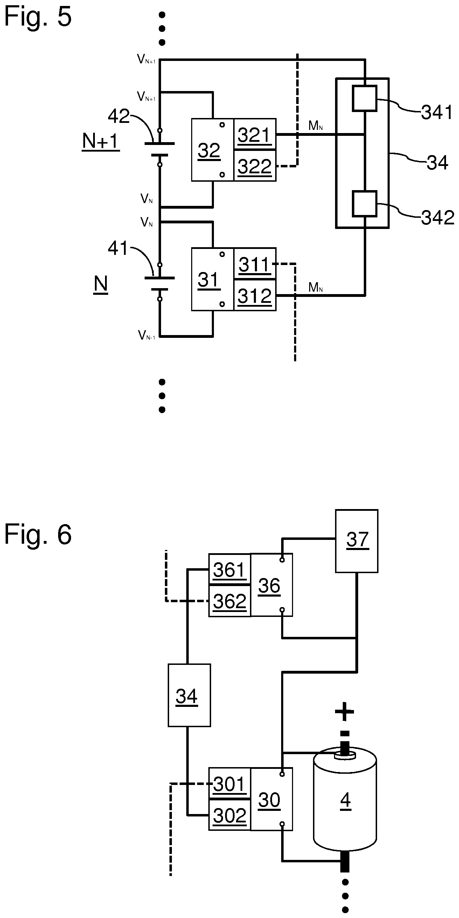

La figure 5 représente un deuxième exemple d'association de dispositifs de contrôle au niveau de deux étages 41 et 42 connectés en série (identifiés respectivement par les indices N et N+1). Les potentiels sont identifiés avec les mêmes références qu'à la figure 3. Un premier dispositif de contrôle 31 est accolé et connecté électriquement à l'étage 41. Le premier dispositif de contrôle 31 est alimenté par les potentiels $V_n$ et $V_{n-1}$. Un deuxième dispositif de contrôle 32 est accolé et connecté électriquement à l'étage 42. Le deuxième dispositif de contrôle 32 est alimenté par les potentiels $V_{n+1}$ et $V_n$.

Dans l'exemple illustré à la figure 5, la communication s'effectue du dispositif de contrôle 31 vers le dispositif de contrôle 32. Le dispositif de contrôle 31 comporte une interface d'entrée 311 et une interface de sortie 312. Le dispositif de contrôle 32 comporte une interface d'entrée 321 et une interface de sortie 322. L'interface de sortie 312 est connectée à l'interface d'entrée 321 par l'intermédiaire d'un convertisseur de niveau de potentiel 34. L'interface d'entrée 311 est connectée à l'interface de sortie du dispositif de contrôle de l'étage d'indice N-1. L'interface de sortie 322 est connectée à l'interface d'entrée du dispositif de contrôle de l'étage d'indice N+2.

Le dispositif de contrôle 31 mesure la différence de potentiel aux bornes de l'étage 41, numérise cette différence de potentiel (éventuellement avec un codage à un unique bit par comparaison à un seuil) et applique sur la sortie 312 la différence de potentiel numérisée (notée $M_n$) sous la forme d'une séquence numérique incluant au moins deux niveaux logiques égaux respectivement à $V_n$ et $V_{n-1}$, par exemple au moyen d'un interrupteur appliquant soit le potentiel $V_{n+1}$ et $V_n$ en sortie. La séquence numérique est appliquée sur une entrée du convertisseur de niveau de potentiel 34. Une sortie du convertisseur 34 est connectée à l'interface d'entrée 321. Une borne de référence du convertisseur 34 est connectée au potentiel $V_{n+1}$. Le convertisseur 34 est configuré pour convertir les niveaux logiques de la séquence numérique appliquée sur son entrée en des niveaux logiques compris entre les potentiels d'alimentation du dispositif de contrôle 32. La séquence numérique sur l'entrée du convertisseur 34 présente deux niveaux logiques respectivement égaux à $V_n$ et $V_{n-1}$, le convertisseur 34 appliquant une séquence numérique sur l'entrée 321 avec deux niveaux logiques compris entre $V_n$ et $V_{n+1}$.

Le convertisseur 34 forme ici un diviseur de tension entre sa borne de référence et son entrée. Le convertisseur 34 comporte par exemple une résistance 341 connectée entre la borne de référence de ce convertisseur 34 et l'entrée 321, et une résistance 342 connectée entre l'entrée 321 et la sortie 312. Par exemple, si les résistances 341 et 342 présentent une même valeur de résistance, la séquence numérique appliquée sur l'entrée 321 présente deux niveaux logiques égaux respectivement à $(V_{n+1} - (V_{n+1} - V_{n-1})/2)$ et $(V_{n-1} - (V_{n+1} - V_n)/2)$. D'autres rapports de division de tension peuvent bien entendu être utilisés, par exemple avec une résistance 342 ayant une valeur de résistance double de celle de la résistance 341.

Le dispositif de contrôle 32 mesure la différence de potentiel aux bornes de l'étage 42 et numérise (éventuellement avec un codage à un unique bit par comparaison à un seuil) cette différence de potentiel (notée $M_{n+1}$). Par ailleurs, le dispositif de contrôle 32 décode la séquence numérique reçue sur l'entrée 321 afin de lire la différence de potentiel $M_n$ de l'étage 41. En outre, le dispositif de contrôle 32 mesure les niveaux logiques de la séquence numérique reçue sur l'entrée 321. À partir des niveaux logiques mesurés sur la séquence numérique reçue sur l'entrée 321, le dispositif de contrôle 32 extrapole la différence de potentiel aux bornes de l'étage 41, en se basant notamment sur la connaissance de la loi de conversion du convertisseur 34. La différence de potentiel extrapolée est notée $E_n$. Si le dispositif de contrôle 32 mesure deux niveaux logiques $NL1_n$ et $NL2_n$, si le convertisseur 34 forme un diviseur de tension avec des résistances 341 et 342 identiques, on obtient $E_n$ par la relation suivante :

$$E_n = |NL1_n - NL2_n| * 2$$

Ainsi, l'extrapolation de la différence de potentiel $E_n$ permet d'assurer une redondance de mesure du potentiel aux bornes de l'étage 41. Cette redondance peut être utilisée soit pour transmettre de façon chaînée les valeurs $M_n$ et $E_n$, soit pour transmettre la valeur $M_n$ avec un indicateur de fiabilité (soit une valeur binaire, soit une valeur d'écart) à une unité centrale ou un dispositif de contrôle maître.

Le dispositif de contrôle 32 applique sélectivement sur la sortie 322 soit la différence de potentiel numérisée $M_{n+1}$, soit la différence de potentiel $M_n$ décodée, soit la différence de potentiel extrapolée $E_n$, soit un indicateur de la fiabilité de la différence de potentiel mesurée $M_n$.

Les dispositifs de contrôle 31 et 32 de la figure 5 peuvent présenter la structure du dispositif de contrôle 30 détaillé en référence à la figure 4.

Les dispositifs de contrôle utilisés peuvent également mettre en oeuvre à la fois une communication ascendante entre dispositifs de contrôle, et une communication descendante entre dispositifs de contrôle. A cet effet, chaque dispositif de contrôle peut comporter deux interfaces d'entrée (une première destinée à communiquer avec une interface de sortie du dispositif de contrôle d'indice supérieur, une deuxième destinée à communiquer avec une interface de sortie du dispositif de contrôle d'indice inférieur) et deux interfaces de sortie (une première destinée à communiquer avec une interface d'entrée du dispositif de contrôle d'indice supérieur, une deuxième destinée à communiquer avec une interface d'entrée du dispositif de contrôle d'indice inférieur).

Pour éviter une distorsion entre les potentiels d'alimentation d'un dispositif de contrôle 30 et les niveaux logiques de la séquence numérique qu'il transmet, les résistances 331 et 332 et 341 et 342 présentent avantageusement des valeurs de résistance relativement élevées, par exemple comprises entre $10k\Omega$ et $1M\Omega$, afin de limiter le courant les traversant. Ainsi, la différence de potentiel extrapolée à partir des niveaux logiques reste assez précise. Une valeur relativement élevée favorise la précision de la différence de potentiel extrapolée, une valeur relativement basse favorise l'immunité au bruit thermique et limite la nécessité d'inclure un filtre d'entrée.

Pour les dispositifs de contrôle disposés aux extrémités de la connexion en série, une redondance de la mesure de la différence de potentiel à son étage peut éventuellement être obtenue par un dispositif de contrôle additionnel. Un tel exemple de configuration est illustré à la figure 6. Un dispositif de contrôle 30 est connecté aux bornes de l'étage 4 connecté à la borne positive de la batterie 2. Un dispositif de contrôle additionnel 36 est alimenté par un convertisseur continu/continu 37 ayant pour référence le potentiel de la borne positive de la batterie 2. Le convertisseur 37 applique un autre potentiel d'alimentation sur le dispositif de contrôle 36. Le dispositif de contrôle 36 comporte une interface d'entrée 361 connectée à l'interface de sortie 302 du dispositif de contrôle 30 par l'intermédiaire d'un convertisseur 34 tel que détaillé auparavant. Une telle configuration permet d'utiliser une même structure pour le dispositif de contrôle 36 et les dispositifs de contrôle 30.

Le décodeur 305 d'un dispositif de contrôle 30 discrimine typiquement deux niveaux logiques dans les séquences numériques reçues en comparant les niveaux de potentiel reçus à un seuil. Si un signal reçu présente un niveau supérieur à ce seuil, le décodeur 305 lui attribue une première valeur numérique, par exemple 1. Si un signal reçu présente un niveau inférieur à ce seuil, le décodeur 305 lui attribue une deuxième valeur numérique, par exemple 0. Afin de limiter le risque d'erreur de décodage, le seuil est avantageusement fixé à la valeur médiane entre les potentiels attendus sur l'interface d'entrée.

Comme un dispositif de contrôle 30 est alimenté par l'étage auquel il est connecté, les potentiels d'alimentation de ce dispositif de contrôle 30 varient en fonction de la charge, du vieillissement, ou de la résistance interne de cet étage, ou encore en fonction du courant débité par cet étage. Par conséquent, les niveaux de potentiel du signal numérique générés et appliqués sur un autre dispositif de contrôle 30 varient. Avantageusement, chaque dispositif de contrôle 30 adapte le seuil de son décodeur 305. L'adaptation du seuil peut être réalisée lors d'une étape d'initialisation durant laquelle un dispositif de contrôle 30 reçoit une séquence numérique provenant d'un autre dispositif de contrôle 30, en fixant le seuil comme une valeur médiane entre les niveaux de potentiel de la séquence numérique reçue. Le seuil peut également être ajusté à une moyenne entre ces niveaux de potentiel sur un certain nombre d'échantillons.

Pour assurer une meilleure immunité aux perturbations, le signal reçu peut être comparé à un seuil haut et à un seuil bas, la première valeur numérique n'étant attribuée au signal reçu que si elle dépasse le seuil haut, et la deuxième valeur numérique n'étant attribuée au signal reçu que si elle est inférieure au seuil bas. La valeur du seuil haut et la valeur du seuil bas peut également être adaptée en fonction des potentiels d'une séquence numérique reçue, par exemple lors d'une séquence d'initialisation.

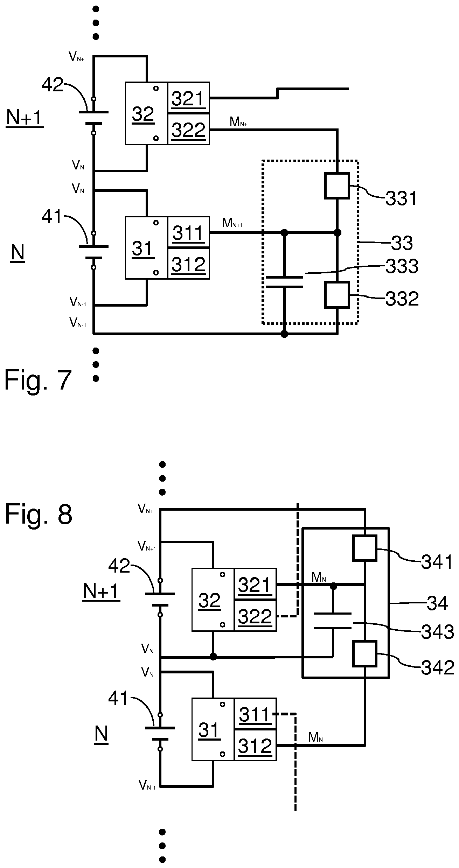

La figure 7 illustre une variante de l'association des dispositifs de contrôle de la figure 3. Dans cet exemple, le convertisseur 33 inclut un filtre limitant la bande passante aux fréquences utilisées pour la communication entre les dispositifs de contrôle. Le filtre est ici de type RC, un condensateur 333 étant connecté en parallèle de la résistance 332.

La figure 8 illustre une variante de l'association des dispositifs de contrôle de la figure 5. Dans cet exemple, le convertisseur 34 inclut un filtre limitant la bande passante aux fréquences utilisées pour la communication entre les dispositifs de contrôle. Le filtre est ici de type RC, un condensateur 343 étant connecté entre l'entrée 321 et le potentiel $V_n$.

Pour un convertisseur de potentiel 33 tel que détaillé auparavant, on peut fixer des règles limitant l'incertitude sur les niveaux logiques des séquences numériques. Si on définit par R331 la valeur de la résistance 331 et par R332 la valeur de la résistance 332, soit a=R331/R332.

Par exemple, pour que les potentiels du signal numérique transmis par le dispositif de contrôle 31 au dispositif de contrôle 32 de la figure 3 soient compris entre les potentiels d'alimentation du dispositif de contrôle 32, la relation suivante doit être vérifiée :

$$0 \leq (V_{n+1} - V_{n-1})/(1+a) \leq (V_n - V_{n-1})$$

Soit k le rapport entre la différence de potentiel maximale d'un étage chargé d'une part, et la différence de potentiel minimale d'un étage déchargé d'autre part, on constate que l'inégalité précédente est vérifiée si k<a.

Une fois le rapport a fixé, il reste à déterminer les ordres de grandeur des résistances R331 et R332. Ces valeurs pourront par exemple être fixées en fonction de l'impédance d'entrée des convertisseurs analogique/numérique 304, et/ou en fonction d'une bande passante souhaitée pour le convertisseur 33.

Pour un convertisseur de potentiel 34 tel que détaillé auparavant, on peut également fixer des règles limitant l'incertitude sur les niveaux logiques des séquences numériques. Si on définit par R341 la valeur de la résistance 341 et par R342 la valeur de la résistance 342, soit b=R342/R341.

Par exemple, pour que les potentiels du signal numérique transmis par le dispositif de contrôle 32 au dispositif de contrôle 31 de la figure 5 soient compris entre les potentiels d'alimentation du dispositif de contrôle 31, la relation suivante doit être vérifiée :

$$0 \leq (V_{n+1} - V_n) * R342/(R341+R342) - (V_n - V_{n-1})*R341/(R341+R342) \leq (V_{n+1} - V_n)$$

Soit k le rapport entre la différence de potentiel maximale d'un étage chargé d'une part, et la différence de potentiel minimale d'un étage déchargé d'autre part, on constate que l'inégalité précédente est vérifiée si k<b.

Une fois les rapports a ou b fixés, il reste à déterminer les ordres de grandeur des résistances R341 et R342. Ces valeurs pourront par exemple être fixées en fonction de l'impédance d'entrée des convertisseurs analogique/numérique 304, et/ou en fonction d'une bande passante souhaitée pour le convertisseur 34.

Chaque dispositif de contrôle peut mettre en oeuvre des commandes reçues d'une unité centrale ou d'un dispositif de contrôle maître, par exemple pour appliquer un courant de décharge aux bornes de son étage. Un tel courant de décharge peut par exemple être mis en oeuvre pour procéder à un équilibrage de charge des étages.

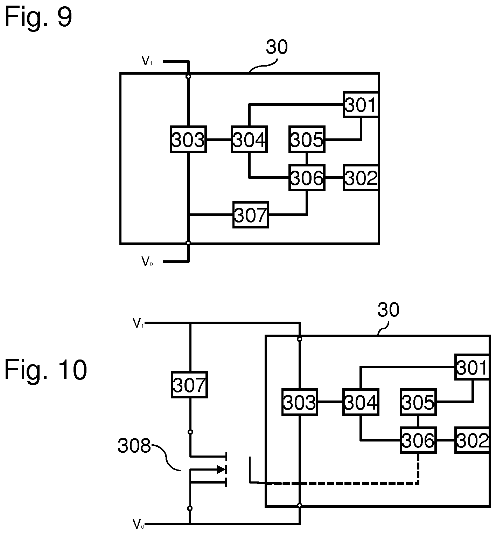

La figure 9 illustre une première variante de dispositif de contrôle 30 configuré pour procéder à une décharge d'équilibrage de son étage. Le dispositif de contrôle 30 comporte une résistance 307 alimentée sélectivement en fonction d'une commande de l'unité de traitement 306. La résistance 307 est ici connectée au potentiel $V_0$ afin de procéder à la décharge de l'étage connecté au dispositif de contrôle 30.

La figure 10 illustre une deuxième variante de dispositif de contrôle 30. Le dispositif de contrôle 30 comprend d'une part un microcontrôleur, un transistor 308 commandé par une unité de traitement 306 du microcontrôleur, et une résistance 307 connectée en série avec le transistor 308 entre les potentiels $V_0$ et $V_1$. Le transistor 308 est ici de type nMos commandé en tout ou rien. Un tel dispositif de contrôle 30 permet d'appliquer un courant de décharge relativement important.

Selon une variante, les dispositifs de contrôle 30 peuvent être configurés pour appliquer leurs potentiels d'alimentation pour des premier et deuxième niveaux logiques, et un état haute indépendance pour un troisième niveau logique. Dans l'exemple de la figure 3, lorsque la sortie 322 est à l'état haute impédance, le potentiel $V_{n-1}$ est appliqué sur l'entrée 311. Le potentiel appliqué sur l'entrée 311 est alors indépendant des différences de potentiel des étages 41 et 42. Les premier et deuxième potentiels d'alimentation du dispositif de contrôle 30 peuvent par exemple coder un 1, et l'état haute impédance peut coder un 0. Les premier et deuxième potentiels d'alimentation peuvent être utilisés par un autre dispositif de contrôle afin d'extrapoler la différence de potentiel et la comparer à la différence de potentiel codée dans la séquence numérique.

Dans l'exemple de la figure 4, lorsque la sortie 312 est à l'état haute impédance, le potentiel $V_{n+1}$ est appliqué sur l'entrée 321. Le potentiel appliqué sur l'entrée 321 est alors stable et permet d'utiliser la pleine amplitude du convertisseur analogique/numérique du dispositif de contrôle 30. Les premier et deuxième potentiels d'alimentation du dispositif de contrôle 30 peuvent par exemple coder un 0, et l'état haute impédance peut coder un 1. Les premier et deuxième potentiels d'alimentation peuvent être utilisés par un autre dispositif de contrôle afin d'extrapoler la différence de potentiel et la comparer à la différence de potentiel codée dans la séquence numérique.

Ainsi, les informations de communication et de redondance peuvent être décorrélées.

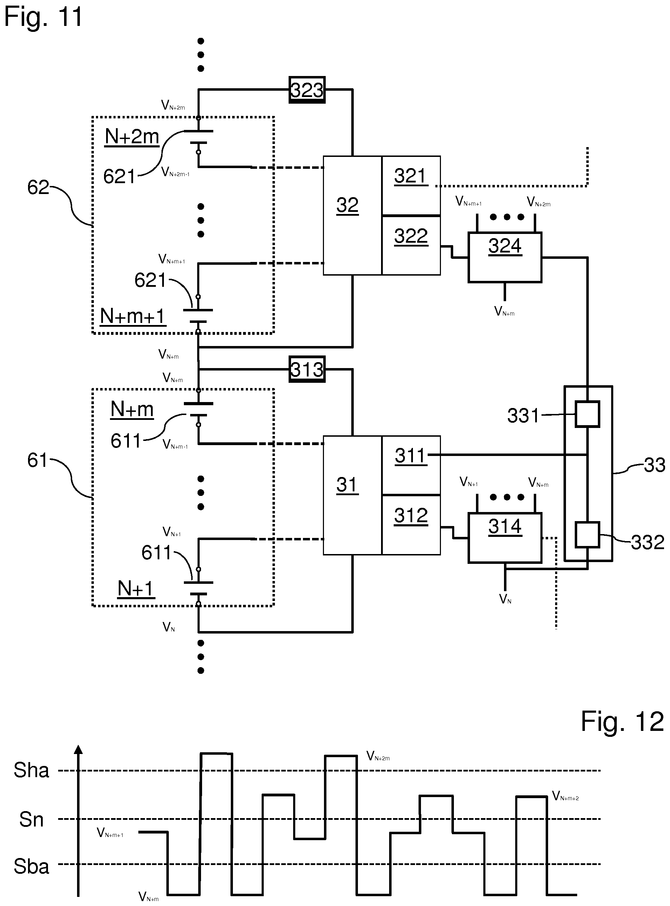

La figure 11 est une représentation schématique d'un autre exemple de système de batterie d'accumulateurs. Cet exemple correspond ici à une communication descendante mais peut être mise en oeuvre de façon ascendante de façon similaire. Afin de réduire le coût du système 1, chaque dispositif de contrôle est mutualisé pour un même module comprenant plusieurs étages en série, tout en conservant la capacité de mesurer la différence de potentiel aux bornes de chaque étage, ce qui est important en termes de sécurité. Le système 1 illustré comprend deux modules 61 et 62 connectés en série. Les modules 61 et 62 sont également connectés en série avec d'autres modules non illustrés. Le module 61 comprend plusieurs accumulateurs 611 connectés en série. Le module 62 comprend plusieurs accumulateurs 621 connectés en série. Chaque étage des modules 61 et 62 illustrés comprend un unique accumulateur, mais chaque étage peut bien entendu comprendre plusieurs accumulateurs connectés en parallèle. Dans un souci de simplification, les modules 61 et 62 comprennent un même nombre m d'accumulateurs connectés en série.

Un premier dispositif de contrôle 31 est accolé et connecté électriquement au module 61. Les différents potentiels $V_N$ à $V_{N+m}$ sont appliqués sur une entrée de mesure du dispositif de contrôle 31. Les différents potentiels $V_{N+1}$ à $V_{N+m}$ sont également appliqués sur une entrée d'un multiplexeur de niveaux analogiques 314. Le potentiel $V_N$ est également appliqué sur une borne de référence du multiplexeur 314. Un deuxième dispositif de contrôle 32 est accolé et connecté électriquement au module 62. Les différents potentiels $V_{N+m}$ à $V_{N+2m}$ sont appliqués sur une entrée de mesure du dispositif de contrôle 32. Les différents potentiels $V_{N+m+1}$ à $V_{N+2m}$ sont également appliqués sur une entrée d'un multiplexeur de niveaux analogiques 324. Le potentiel $V_{N+m}$ est également appliqué sur une borne de référence du multiplexeur 324. En fonction d'un signal appliqué sur une borne de commande, les multiplexeurs analogiques appliquent sélectivement sur leur sortie un des potentiels reçus sur une entrée ou sur la borne de référence.

Afin de disposer d'une tension d'alimentation stable, avec un niveau compatible avec un dispositif de contrôle de tension, et avec une consommation identique pour les différents accumulateurs en série dans un module, les dispositifs de contrôle sont avantageusement alimentés par l'intermédiaire de circuits de régulation de tension connectés aux bornes de l'ensemble du module. Dans l'exemple, le dispositif de contrôle 31 est muni d'un circuit de régulation de tension 313 et le dispositif de contrôle 32 est muni d'un circuit de régulation de tension 323. Les circuits de régulation de tension 313 et 323 sont ici des convertisseurs abaisseurs de tension, leur entrée étant alimentée par la différence de tension aux bornes de leur module respectif. Si on définit par $V_m$ la différence de potentiel (supposée sensiblement identique pour l'ensemble des étages), les circuits de régulation de tension 313 et 323 alimentent avantageusement leur dispositif de contrôle respectif avec cette différence de potentiel Vm.

Dans l'exemple illustré à la figure 11, la communication s'effectue du dispositif de contrôle 32 vers le dispositif de contrôle 31. Le dispositif de contrôle 31 comporte une interface d'entrée 311 et une interface de sortie 312. L'interface de sortie 312 est connectée à une entrée de commande du multiplexeur 314. Le dispositif de contrôle 32 comporte une interface d'entrée 321 et une interface de sortie 322. L'interface de sortie 322 est connectée à la borne de commande du multiplexeur 324. La sortie du multiplexeur 324 est connectée à l'interface d'entrée 311 par l'intermédiaire d'un convertisseur de niveau de potentiel 33. Le convertisseur 33 forme ici un diviseur de tension entre sa borne de référence et son entrée, comme détaillé dans un exemple précédent. Le convertisseur 33 comporte ici une résistance 331 connectée entre le multiplexeur 324 et l'entrée 311, et une résistance 332 connectée entre l'entrée 311 et le potentiel de référence $V_N$ du dispositif de contrôle 31.

Le dispositif de contrôle 32 mesure le potentiel de la borne supérieure d'un accumulateur d'indice k (avec k compris entre 1 et m) ou la différence de potentiel aux bornes de cet accumulateur du module 62. La mesure est numérisée et une séquence numérique est appliquée sur la sortie 322 pour sélectionner une entrée du multiplexeur 324 qui fournira un niveau logique haut ou la borne de référence qui fournira un niveau logique bas. Le multiplexeur 324 dispose de m+1 potentiels d'entrée différents.

Avantageusement, certains potentiels (par exemple les potentiels $V_{N+m}$ à $V_{N+m/2}$) sont utilisés pour coder un niveau logique bas, et d'autres potentiels (par exemple les potentiels $V_{N+m/2+1}$ à $V_{N+2m}$) sont utilisés pour coder un niveau logique haut. On fixe un seuil numérique Sn à une valeur comprise entre $V_{N+m/2}$ et $V_{N+2m+1}$. La séquence numérique générée par l'intermédiaire du multiplexeur 324 pourra utiliser différents potentiels pour un état haut. De même, la séquence numérique générée par l'intermédiaire du multiplexeur 314 pourra utiliser différents potentiels pour un état haut. Le dispositif de contrôle 31 pourra ainsi disposer de façon redondante des potentiels à chaque borne des accumulateurs 621.

La figure 12 est un diagramme illustrant un exemple de potentiel appliqué sur la sortie du multiplexeur 324 lors de la génération d'une séquence numérique dans un cas simplifié à 3 accumulateurs en série dans le module 62. Les potentiels $V_{N+m}$ et $V_{N+m+1}$ codent un 0, alors que les potentiels $V_{N+m+2}$ et $V_{N+2m}$ codent un 1. Un seuil analogique bas Sba permet de discriminer les potentiels codant un 0, un seuil analogique haut Sha permettant de discriminer les potentiels codant un 1. Avec des seuils analogiques appropriés, le dispositif de contrôle 31 peut identifier l'accumulateur 621 dont le potentiel a été utilisé dans un bit donné de la séquence numérique.

Les différents seuils pourront être adaptés dans le temps en fonction de l'évolution des potentiels reçus par le dispositif de contrôle 31.

La transmission par un multiplexeur 324 pourra également être effectuée par l'intermédiaire de deux sorties appliquées sur des convertisseurs respectifs. Pour transmettre un premier niveau logique, une première sortie du multiplexeur 324 pourra par exemple appliquer le potentiel $V_{N+m+k}$ et une deuxième sortie pourra appliquer le potentiel

$V_{N+m+k-1}$. Pour transmettre un deuxième niveau logique, les première et deuxième sorties du multiplexeur 324 pourront appliquer le potentiel $V_{N+m}$.

**Revendications**

1. Système (1) de batterie d'accumulateurs, comprenant:

   - des premier et deuxième étages d'accumulateurs électrochimiques (41, 42) connectés en série ;
   - un premier dispositif de contrôle (31) alimenté par l'intermédiaire des potentiels aux bornes d'au moins un accumulateur du premier étage, configuré pour mesurer la différence de potentiel entre les bornes d'un accumulateur du premier étage, comprenant une première interface de sortie (312), et comprenant un premier convertisseur analogique/numérique configuré pour coder la différence de potentiel mesurée entre les bornes dudit accumulateur du premier étage, ladite première interface de sortie étant configurée pour délivrer une première séquence numérique correspondant à la différence de potentiel codée, avec des niveaux logiques définis par au moins deux potentiels aux bornes d'accumulateurs du premier étage;
   - un deuxième dispositif de contrôle (32) alimenté par l'intermédiaire des potentiels aux bornes d'au moins un accumulateur du deuxième étage, configuré pour mesurer la différence de potentiel entre les bornes d'un accumulateur du deuxième étage, comprenant une interface d'entrée (321), comprenant une deuxième interface de sortie (322), comprenant un décodeur configuré pour décoder la différence de potentiel mesurée par le premier dispositif de contrôle à partir de la première séquence numérique reçue sur l'interface d'entrée, et comprenant un deuxième convertisseur analogique/numérique;
   - un convertisseur de niveau de potentiel (34) configuré pour convertir deux potentiels de la première séquence numérique appliquée par la première interface de sortie en deux potentiels compris entre les potentiels d'alimentation du deuxième dispositif de contrôle, et configuré pour appliquer la première séquence numérique convertie sur l'interface d'entrée du deuxième dispositif de contrôle, caractérisé en ce que

   le deuxième convertisseur analogique/numérique est configuré pour coder sélectivement :

   - la différence de potentiel mesurée entre les bornes dudit accumulateur du deuxième étage ; ou
   - deux potentiels de la séquence numérique reçue sur l'interface d'entrée ;

   le deuxième dispositif de contrôle comprenant un dispositif de traitement configuré pour extrapoler la différence de potentiel aux bornes dudit accumulateur du premier étage à partir de deux potentiels de la séquence numérique reçue; et
   la deuxième interface de sortie étant configurée pour délivrer une deuxième séquence numérique correspondant sélectivement à la différence de potentiel codée, à la différence de potentiel décodée, ou à une information représentative de la différence de potentiel extrapolée par le dispositif de traitement.

2. Système (1) de batterie d'accumulateurs selon la revendication 1, dans lequel ledit convertisseur de niveau de potentiel (34) comporte un diviseur de tension présentant :

   - une première charge électrique (342) connectée entre la première interface de sortie (312) du premier dispositif de contrôle (31) et l'interface d'entrée (321) du deuxième dispositif de contrôle (32) ;
   - une deuxième charge électrique (341) connectée entre l'interface d'entrée (321) du deuxième dispositif de contrôle (32) et un desdits potentiels d'alimentation du deuxième dispositif de contrôle.

3. Système (1) de batterie d'accumulateurs selon la revendication 2, dans lequel le deuxième étage présente une différence de potentiel de fonctionnement maximale Vmax à ses bornes et une différence de potentiel de fonctionnement minimale Vmin à ses bornes, dans lequel la première charge électrique présente une impédance R1 et dans lequel la deuxième charge électrique présente une impédance R2, lesdites impédances R1 et R2 étant telles que R1/R2> Vmax/Vmin.

4. Système de batterie d'accumulateurs selon l'une quelconque des revendications précédentes, dans lequel la première séquence numérique comprend deux niveaux logiques définis respectivement par lesdits potentiels aux bornes du premier étage.

5. Système (1) de batterie d'accumulateurs selon la revendication 1, dans lequel le premier étage d'accumulateurs (61) et le deuxième étage d'accumulateurs (62) comprennent chacun plusieurs accumulateurs électrochimiques (611, 621) connectés en série, ledit premier dispositif de contrôle étant configuré pour mesurer la différence de potentiel entre les bornes de chacun des accumulateurs du premier étage, ledit deuxième dispositif de contrôle étant configuré pour mesurer la différence de potentiel entre les bornes de chacun des accumulateurs du deuxième étage, au moins un desdits niveaux logiques de la première séquence numérique étant défini par un potentiel à une borne d'un desdits accumulateurs du premier étage.

6. Système de batterie d'accumulateurs selon la revendication 5, dans lequel ledit premier dispositif de contrôle (31) est alimenté par l'intermédiaire d'un convertisseur (313) abaisseur de tension recevant en entrée la différence de potentiel entre les bornes du premier étage d'accumulateurs.

7. Système (1) de batterie d'accumulateurs selon l'une quelconque des revendications précédentes, dans lequel ledit convertisseur de niveau de potentiel (34) est dépourvu d'isolation galvanique.

8. Système (1) de batterie d'accumulateurs selon l'une quelconque des revendications précédentes, dans lequel lesdits premier et deuxième dispositifs de contrôle sont configurés pour appliquer sélectivement un courant de décharge sur les premier et deuxième étages respectivement, dans lequel ledit premier dispositif de contrôle comporte un dispositif de traitement, lesdits dispositifs de traitement des premier et deuxième dispositifs de contrôle étant configurés pour sélectivement commander l'application ou l'interruption d'un courant de décharge sur leur étage respectif en fonction d'une séquence numérique reçue sur une interface d'entrée respective.

9. Système (1) de batterie d'accumulateurs selon la revendication 8, comprenant en outre un circuit de commande (5) connecté à une interface de sortie dudit premier dispositif de contrôle ou dudit deuxième dispositif de contrôle par l'intermédiaire d'un circuit d'isolation galvanique (51,52), le circuit de commande étant configuré pour décoder une séquence numérique reçue dudit première ou deuxième dispositif de contrôle et incluant une valeur de différence de potentiel.

10. Système (1) de batterie d'accumulateurs selon la revendication 9, dans lequel le circuit de commande (5) est connecté à une interface d'entrée d'un dispositif de contrôle par l'intermédiaire d'un circuit d'isolation galvanique, et le circuit de commande est configuré pour générer une séquence numérique commandant l'application ou l'interruption d'un courant de décharge par ce dispositif de contrôle sur son étage.

11. Système (1) de batterie d'accumulateurs selon l'une quelconque des revendications précédentes, dans lequel un niveau logique de la première séquence numérique délivrée sur la première interface de sortie du premier dispositif de contrôle (31) est défini par application d'un état haute impédance sur cette première interface de sortie.

12. Système (1) de batterie d'accumulateurs selon l'une quelconque des revendications précédentes, dans lequel ledit décodeur (305) du deuxième dispositif de contrôle (32) est configuré pour décoder la différence de potentiel mesurée par le premier dispositif de contrôle en comparant la première séquence numérique reçue sur l'interface d'entrée (321) à au moins un seuil de potentiel, ledit deuxième dispositif de contrôle étant configuré pour modifier la valeur dudit seuil de potentiel en fonction d'au moins un potentiel d'une séquence numérique reçue sur l'interface d'entrée.

**Patentansprüche**

1. System (1) einer Akkumulatorenbatterie, das enthält:

- erste und zweite elektrochemische Akkumulatorenstufen (41, 42) in Reihe geschaltet;
- eine erste Kontrollvorrichtung (31), die mittels der Potentiale an den Klemmen mindestens eines Akkumulators der ersten Stufe versorgt wird, die konfiguriert ist, die Potentialdifferenz zwischen den Klemmen eines Akkumulators der ersten Stufe zu messen, die eine erste Ausgangsschnittstelle (312) enthält, und einen ersten Analog/Digital-Wandler enthält, der konfiguriert ist, um die zwischen den Klemmen des Akkumulators der ersten Stufe gemessene Potentialdifferenz zu codieren, wobei die erste Ausgangsschnittstelle konfiguriert ist, um eine erste digitale Sequenz zu liefern, die der codierten Potentialdifferenz entspricht, mit Logikpegeln definiert durch mindestens zwei Potentiale an den Klemmen von Akkumulatoren der ersten Stufe;
- eine zweite Kontrollvorrichtung (32), die über die Potentiale an den Klemmen mindestens eines Akkumulators der zweiten Stufe versorgt wird, die konfiguriert ist, um die Potentialdifferenz zwischen den Klemmen eines Akkumulators der zweiten Stufe zu messen, die eine Eingangsschnittstelle (321) enthält, die eine zweite Ausgangsschnittstelle (322) enthält, die einen Decoder enthält, der konfiguriert ist, um die von der ersten Kontrollvorrichtung gemessene Potentialdifferenz ausgehend von der an der Eingangsschnittstelle empfangenen ersten digitalen Sequenz zu decodieren, und einen zweiten Analog/DigitalWandler enthält;
- einen Potentialpegelwandler (34), der konfiguriert ist, um zwei Potentiale der ersten digitalen Sequenz, die von der ersten Ausgangsschnittstelle angewendet wird, in zwei Potentiale umzuwandeln, die zwischen den Versorgungspotentialen der zweiten Kontrollvorrichtung liegen, und konfiguriert ist, um die erste umgewandelte digitale Sequenz an die Eingangsschnittstelle der zweiten Kontrollvorrichtung anzulegen,

**dadurch gekennzeichnet, dass** der zweite Analog/Digital-Wandler konfiguriert ist, um selektiv zu codieren:

- die zwischen den Klemmen des Akkumulators der zweiten Stufe gemessene Potentialdifferenz; oder
- zwei Potentiale der an der Eingangsschnittstelle empfangenen digitalen Sequenz;

wobei die zweite Kontrollvorrichtung eine Verarbeitungsvorrichtung enthält, die konfiguriert ist, um die Potentialdifferenz an den Klemmen des Akkumulators der ersten Stufe ausgehend von zwei Potentialen der empfangenen digitalen Sequenz zu extrapolieren; und
die zweite Ausgangsschnittstelle konfiguriert ist, um eine zweite digitale Sequenz zu liefern, die selektiv der codierten Potentialdifferenz, der decodierten Potentialdifferenz, oder einer Information entspricht, die für die durch die Verarbeitungsvorrichtung extrapolierte Potentialdifferenz repräsentativ ist.

2.  System (1) einer Akkumulatorenbatterie nach Anspruch 1, wobei der Potentialpegelwandler (34) einen Spannungsteiler aufweist, der hat:

- eine erste elektrische Last (342), die zwischen der ersten Ausgangsschnittstelle (312) der ersten Kontrollvorrichtung (31) und der Eingangsschnittstelle (321) der zweiten Kontrollvorrichtung (32) angeschlossen ist;
- eine zweite elektrische Last (341), die zwischen der Eingangsschnittstelle (321) der zweiten Kontrollvorrichtung (32) und einem der Versorgungspotentiale der zweiten Kontrollvorrichtung angeschlossen ist.

3.  System (1) einer Akkumulatorenbatterie nach Anspruch 2, wobei die zweite Stufe eine maximale Betriebspotentialdifferenz Vmax an ihren Klemmen und eine minimale Betriebspotentialdifferenz Vmin an ihren Klemmen hat, wobei die erste elektrische Last eine Impedanz R1 hat, und wobei die zweite elektrische Last eine Impedanz R2 hat, wobei die Impedanzen R1 und R2 so sind, dass gilt R1/R2> Vmax/Vmin.

4.  System einer Akkumulatorenbatterie nach einem der vorhergehenden Ansprüche, wobei die erste digitale Sequenz zwei Logikpegel enthält, die je durch die Potentiale an den Klemmen der ersten Stufe definiert werden.

5.  System (1) einer Akkumulatorenbatterie nach Anspruch 1, wobei die erste Stufe von Akkumulatoren (61) und die zweite Stufe von Akkumulatoren (62) je mehrere in Reihe geschaltete elektrochemische Akkumulatoren (611, 621) enthalten, wobei die erste Kontrollvorrichtung konfiguriert ist, um die Potentialdifferenz zwischen den Klemmen jedes der Akkumulatoren der ersten Stufe zu messen, wobei die zweite Kontrollvorrichtung konfiguriert ist, um die Potentialdifferenz zwischen den Klemmen jedes der Akkumulatoren der zweiten Stufe zu messen, wobei mindestens einer der Logikpegel der ersten digitalen Sequenz durch ein Potential an einer Klemme eines der Akkumulatoren der ersten Stufe definiert wird.

6.  System einer Akkumulatorenbatterie nach Anspruch 5, wobei die erste Kontrollvorrichtung (31) über einen Spannungsabwärtswandler (313) versorgt wird, der am Eingang die Potentialdifferenz zwischen den Klemmen der ersten Stufe von Akkumulatoren empfängt.

7.  System (1) einer Akkumulatorenbatterie nach einem der vorhergehenden Ansprüche, wobei der Potentialpegelwandler (34) keine galvanische Trennung aufweist.

8.  System (1) einer Akkumulatorenbatterie nach einem der vorhergehenden Ansprüche, wobei die ersten und zweiten Kontrollvorrichtungen konfiguriert sind, um selektiv einen Entladestrom an die ersten bzw. zweiten Stufen anzulegen, wobei die erste Kontrollvorrichtung eine Verarbeitungsvorrichtung aufweist, wobei die Verarbeitungsvorrichtungen der ersten und zweiten Kontrollvorrichtungen konfiguriert sind, um selektiv das Anlegen oder die Unterbrechung eines Entladestroms an ihrer jeweilige Stufe abhängig von einer an einer jeweiligen Eingangsschnittstelle empfangenen digitalen Sequenz zu steuern.

9. System (1) einer Akkumulatorenbatterie nach Anspruch 8, das außerdem eine Steuerschaltung (5) enthält, die an eine Ausgangsschnittstelle der ersten Kontrollvorrichtung oder der zweiten Kontrollvorrichtung über eine galvanische Trennschaltung (51,52) angeschlossen ist, wobei die Steuerschaltung konfiguriert ist, um eine von der ersten oder zweiten Kontrollvorrichtung empfangene und einen Potentialdifferenzwert umfassende digitale Sequenz zu decodieren.

10. System (1) einer Akkumulatorenbatterie nach Anspruch 9, wobei die Steuerschaltung (5) über eine galvanische Trennschaltung an eine Eingangsschnittstelle einer Kontrollvorrichtung angeschlossen ist, und die Steuerschaltung konfiguriert ist, um eine digitale Sequenz zu erzeugen, die das Anlegen oder Unterbrechen eines Entladestroms durch diese Kontrollvorrichtung an ihrer Stufe steuert.

11. System (1) einer Akkumulatorenbatterie nach einem der vorhergehenden Ansprüche, wobei ein Logikpegel der ersten digitalen Sequenz, die an der ersten Ausgangsschnittstelle der ersten Kontrollvorrichtung (31) geliefert wird, durch Anwendung eines Zustands hoher Impedanz an dieser ersten Ausgangsschnittstelle definiert wird.

12. System (1) einer Akkumulatorenbatterie nach einem der vorhergehenden Ansprüche, wobei der Decoder (305) der zweiten Kontrollvorrichtung (32) konfiguriert ist, um die von der ersten Kontrollvorrichtung gemessene Potentialdifferenz zu decodieren, indem die erste an der Eingangsschnittstelle (321) empfangene digitale Sequenz mit mindestens einer Potentialschwelle verglichen wird, wobei die zweite Kontrollvorrichtung konfiguriert ist, um den Wert der Potentialschwelle abhängig von mindestens einem Potential einer an der Eingangsschnittstelle empfangenen digitalen Sequenz zu ändern.

## Claims

1. Accumulator battery system (1), comprising:

   - first and second electrochemical accumulator stages (41, 42) connected in series;
   - a first control device (31) powered via the potentials across the terminals of at least one accumulator of the first stage, configured to measure the potential difference between the terminals of an accumulator of the first stage, comprising a first output interface (312), and comprising a first analog/digital converter configured to encode the potential difference measured between the terminals of said accumulator of the first stage, said first output interface being configured to deliver a first digital sequence corresponding to the encoded potential difference, with logic levels defined by at least two potentials across the accumulator terminals of the first stage;
   - a second control device (32) powered via the potentials across the terminals of at least one accumulator of the second stage, configured to measure the potential difference between the terminals of an accumulator of the second stage, comprising an input interface (321), comprising a second output interface (322), comprising a decoder configured to decode the potential difference measured by the first control device from the first digital sequence received on the input interface, and comprising a second analog/digital converter;
   - a potential level converter (34) configured to convert two potentials of the first digital sequence applied by the first output interface into two potentials between the supply potentials of the second control device, and configured to apply the first digital sequence converted to the input interface of the second control device, **characterized in that** the second analog/digital converter is configured to selectively encode:

     - the potential difference measured between the terminals of said accumulator of the second stage; or
     - two potentials of the digital sequence received on the input interface;

   the second control device comprising a processing device configured to extrapolate the potential difference across the terminals of said accumulator of the first stage based on two potentials of the digital sequence received; and the second output interface being configured to deliver a second digital sequence selectively corresponding to the encoded potential difference, to the decoded potential difference, or to information representative of the potential difference extrapolated by the processing device.

2. Accumulator battery system (1) according to Claim 1, wherein said potential level converter (34) has a voltage divider featuring:

   - a first electric load (342) connected between the first output interface (312) of the first control device (31) and the input interface (321) of the second control device (32);

- a second electric load (341) connected between the input interface (321) of the second control device (32) and one of said supply potentials of the second control device.

3. Accumulator battery system (1) according to Claim 2, wherein the second stage has a maximum operating potential difference Vmax at its terminals and a minimum operating potential difference Vmin at its terminals, wherein the first electric load has an impedance R1 and wherein the second electric load has an impedance R2, said impedances R1 and R2 being such that R1/R2 > Vmax/Vmin.

4. Accumulator battery system according to anyone of the preceding claims, wherein the first digital sequence comprises two logic levels defined by said potentials across the terminals of the first stage, respectively.

5. Accumulator battery system (1) according to Claim 1, wherein the first stage of accumulators (61) and the second stage of accumulators (62) each comprise several electrochemical accumulators (611, 621) connected in series, said first control device being configured to measure the potential difference between the terminals of each of the accumulators of the first stage, said second control device being configured to measure the potential difference between the terminals of each of the accumulators of the second stage, at least one of said logic levels of the first digital sequence being defined by a potential at one terminal of one of said accumulators of the first stage.

6. Accumulator battery system according to Claim 5, wherein said first control device (31) is powered through a voltage step-down converter (313) receiving, at the input, the potential difference between the terminals of the first stage of accumulators.

7. Accumulator battery system (1) according to any one of the preceding claims, wherein said potential level converter (34) is free of galvanic isolation.

8. Accumulator battery system (1) according to any one of the preceding claims, wherein said first and second control devices are configured to selectively apply a discharge current to the first and second stages respectively, wherein said first control device has a processing device, said processing devices of the first and second control devices being configured to selectively control the application or the interruption of a discharge current on their respective stage based on a digital sequence received on a respective input interface.

9. Accumulator battery system (1) according to Claim 8, further comprising a control circuit (5) connected to an output interface of said first control device or said second control device by means of a galvanic isolation circuit (51, 52), the control circuit being configured to decode a digital sequence received from said first or second control device and including a potential difference value.

10. Accumulator battery system (1) according to Claim 9, wherein the control circuit (5) is connected to an input interface of a control device by means of a galvanic isolation circuit, and the control circuit is configured to generate a digital sequence controlling the application or the interruption of a discharge current by this control device on its stage.

11. Accumulator battery system (1) according to any one of the preceding claims, wherein a logic level of the first digital sequence delivered on the first output interface of the first control device (31) is defined by applying a high impedance state on this first output interface.

12. Accumulator battery system (1) according to any one of the preceding claims, wherein said decoder (305) of the second control device (32) is configured to decode the potential difference measured by the first control device by comparing the first digital sequence received on the input interface (321) to at least one potential threshold, said second control device being configured to change the value of said potential threshold according to at least one potential of a digital sequence received on the input interface.

Fig. 1

Fig. 2

Fig. 3

Fig. 4

Fig. 5

Fig. 6

Fig. 7

Fig. 8

Fig. 9

Fig. 10

Fig. 11

Fig. 12

## RÉFÉRENCES CITÉES DANS LA DESCRIPTION

**Documents brevets cités dans la description**

- US 2008180106 A
- DE 102011005603

- US 6411912 B